# EUROPEAN PATENT SPECIFICATION

(11) **EP 4 420 875 B1**
(45) Date of publication and mention of the grant of the patent: **05.08.2026**
(21) Application number: 23740369.6
(22) Date of filing: 17.01.2023
(51) Int. Cl.: C09J 151/06, B32B 27/00, C09J 11/06, C09J 123/30, C09J 7/10, C09J 7/22, H05K 1/03, C08F 255/02, C09J 7/30

(54) **ADHESIVE COMPOSITION, ADHESIVE SHEET, ELECTROMAGNETIC WAVE SHIELD FILM, LAMINATE, AND PRINTED CIRCUIT BOARD**
HAFTZUSAMMENSETZUNG, HAFTFOLIE, ELEKTROMAGNETISCHE WELLENABSCHIRMUNGSFOLIE, LAMINAT UND DRUCKLEITERPLATTE
COMPOSITION ADHÉSIVE, FEUILLE ADHÉSIVE, FILM DE BLINDAGE CONTRE LES ONDES ÉLECTROMAGNÉTIQUES, STRATIFIÉ ET CARTE DE CIRCUIT IMPRIMÉ

(30) Priority: 17.01.2022 JP 2022005258
(43) Date of publication of application: 28.08.2024
(73) Proprietor: TOYOBO MC Corporation, Osaka-shi, Osaka 530-0001 (JP)
(72) Inventor: SONODA Ryo, Otsu-shi, Shiga 520-0292 (JP); KAWAKUSU Tetsuo, Otsu-shi, Shiga 520-0292 (JP)
(74) Representative: Müller-Boré & Partner Patentanwälte PartG mbB
(86) International application number: PCT/JP2023/001208
(87) International publication number: WO 2023/136361

(56) References cited:
- WO-A1-2021/024702
- JP-A- 2000 103 969
- JP-A- 2004 099 519
- JP-A- 2005 105 203
- JP-A- 2019 502 809
- JP-A- 2020 063 353
- JP-A- 2021 003 886
- JP-A- H08 109 333
- US-A1- 2021 309 917

## Description

### TECHNICAL FIELD

The present invention relates to an adhesive composition, particularly to an adhesive composition for adhering a resin substrate to another resin substrate or a metal substrate. In particular, the present invention relates to an adhesive composition for a flexible printed circuit board (hereinafter referred to as FPC), as well as an adhesive sheet, an electromagnetic wave shield material, a laminate, and a printed circuit board, comprising the same.

### BACKGROUND ART

Flexible printed circuits (FPCs) have great flexibility. Due to the flexibility, FPCs make it possible for electronic circuit boards to be incorporated into narrow and complicated internal space of electronic devices, allowing electronic devices such as personal computers (PCs) and smartphones to be multifunctional and more compact. In recent years, there has been a trend towards miniaturization, lightweight design, higher density, and higher output of electronic devices. These trends have led to an increasing demand for the performance of circuit boards (electronic circuit boards). In particular, high frequency signals have been used with an increase in the speed of transmission signals in FPCs. As a result, a demand for low dielectric properties (low dielectric constant, low dielectric dissipation factor) in the high-frequency region has been increasing for FPCs. To achieve low dielectric properties of FPCs in high frequency region, substrates and adhesives for FPCs can have reduced dielectric loss. As the adhesive composition having such low dielectric properties, for example, Patent Document 1 discloses an adhesive composition comprising an acid-modified polyolefin resin that is modified through grafting reaction with modifier containing α,β-unsaturated carboxylic acid or a derivative thereof, and an epoxy resin. Further, most adhesive compositions for FPCs are flammable, and adhesive compositions are required to have flame retardance. A flame retardant containing an organic halogen compound is known to have high flame retardance. However, the flame retardant generates corrosive halogen gas during combustion. In order to address such problem, Patent Document 2 discloses, for example, a resin composition comprising a vinyl compound having a specific chemical structure and a specific weight average molecular weight, a thermoplastic elastomer, curable resins such as epoxy resin, a curing agent, and an organic aluminium phosphinate. Patent document 3 relates to an adhesive composition for a flexible printed wiring board, and an adhesive sheet, a laminate and a printed wiring board containing the same; said composition comprising an acid-modified polyolefin, an epoxy resin, and a flame retardant. Patent document 4 relates to a flame retardant for thermosetting resin including an aromatic phosphoric acid ester, a thermosetting resin composition including the flame retardant, a cured material of the composition, as well as a prepreg, laminate, and a printed wiring board comprising said composition.

### CITATION LISTS

### PATENT LITERATURES

Patent Document 1 : WO 2016/047289
Patent Document 2 : JP-A-2014-34668
Patent Document 3: WO2021/024702 A1
Patent Document 4: US2021/309917 A1

### SUMMARY OF THE INVENTION

### PROBLEMS TO BE SOLVED BY THE INVENTION

Although the adhesive composition disclosed in Patent Document 1 exhibits a positive result in solder heat resistance in a dry environment, this result does not necessarily enable excellent solder heat resistance of an adhesive for FPCs produced in various environments, such as an environment at high temperature and high humidity. Patent Document 2 discloses dielectric constant and flame resistance of the adhesive composition; however, in the provided examples, only the adhesiveness to copper foil is disclosed. The adhesiveness to a polyimide substrate and a liquid crystal polymer (LCP) substrate is not evaluated in Patent Document 2 and such adhesiveness is still unknown. In addition, the solder heat resistance required for FPC applications is not described in the patent document, and it seems that the inventors of the patent document seem not to be aware of the importance of the solder heat resistance. In those patent documents, insulation reliability in an environment at high temperature and high humidity is not examined.

As a result of diligent studies to solve above problems, the inventors have identified an adhesive composition with a specific composition. The adhesive composition exhibits high adhesiveness to both of resin substrates such as polyimide film and metal substrates such as copper foil, as well as excellent solder heat resistance, low dielectric properties, high insulation reliability, and flame retardance rated as VTM-0 according to UL-94 standards. In this manner, the present invention has been completed.

It is an object of the present invention to provide an adhesive composition having high adhesiveness to various resin substates such as polyimide and metal substrates, as well as excellent solder heat resistance, excellent low dielectric properties, high insulation reliability, and high flame retardance.

### SOLUTION TO THE PROBLEMS

[1] An adhesive composition comprising an acid-modified polyolefin (a), a curing agent (b), and a phosphorus flame retardant (c), wherein the phosphorus flame retardant (c) contains an alicyclic structure in a molecule.
[2] The adhesive composition according to [1], wherein the adhesive composition comprises the phosphorus flame retardant (c) in an amount of from 1 to 60 parts by mass with respect to 100 parts by mass of the total amount of the acid-modified polyolefin (a) and the curing agent (b).
[3] The adhesive composition according to [1] or [2], wherein the acid-modified polyolefin (a) has an acid value of from 5 to 40 mgKOH/g.
[4] The adhesive composition according to any one of [1] to [3], wherein the curing agent (b) comprises at least one selected from the group consisting of epoxy resins, polyisocyanates, and polycarbodiimides.
[5] The adhesive composition according to any one of [1] to [4], wherein the phosphorus flame retardant (c) further contains an aromatic ring in a molecule.
[6] The adhesive composition according to any one of [1] to [5], wherein the phosphorus flame retardant (c) is amorphous.
[7] The adhesive composition according to any one of [1] to [6], wherein the adhesive composition comprises the curing agent (b) in an amount of from 0.5 to 60 parts by mass with respect to 100 parts by mass of the acid-modified polyolefin (a).
[8] The adhesive composition according to any one of [1] to [7], wherein the adhesive composition has a relative permittivity at 10 GHz of less than 3.0.
[9] An adhesive sheet comprising a layer including the adhesive composition according to any one of [1] to [8].
[10] An electromagnetic wave shield film comprising a layer including the adhesive composition according to any one of [1] to [8].
[11] A laminate comprising a layer including the adhesive composition according to any one of [1] to [8].
[12] A printed circuit board comprising the laminate according to [11].
[13] The adhesive composition according to any one of [1] to [8], wherein the phosphorus flame retardant (c) comprises a phosphorus flame retardant represented by Formula (1).
[14] The adhesive composition according to any one of [1] to [8], wherein the phosphorus flame retardant (c) comprises one or two or more selected from the group consisting of phosphorus flame retardants represented by Formulae (2) to (5).
[15] An adhesive sheet comprising a layer including the adhesive composition according to [13] or [14].
[16] An electromagnetic wave shield film comprising a layer including the adhesive composition according to [13] or [14].
[17] A laminate comprising a layer including the adhesive composition according to [13] or [14].

### ADVANTAGEOUS EFFECTS OF THE INVENTION

The adhesive composition according to the present invention has high adhesiveness to both various resin substates such as polyimide and metal substrates, excellent solder heat resistance, low dielectric properties, high insulation reliability, and high flame retardance.

### MODE FOR CARRYING OUT THE INVENTION

### <Acid-modified polyolefin resin (a)>

The acid-modified polyolefin resin (a) (hereinafter merely referred to as component (a) in some cases) in the present invention is not particularly limited. The acid-modified polyolefin resin (a) is preferably obtained by grafting at least one of an α,β-unsaturated carboxylic acid and an acid anhydride thereof onto a polyolefin resin. The polyolefin resin indicates a polymer with a mainly hydrocarbon skeleton such as a homopolymer of one of olefin monomers such as ethylene, propylene, butene, butadiene, and isoprene, a copolymer of at least 2 species of the olefin monomers described above, or a hydride or a halide of the obtained polymer. The acid-modified polyolefin resin (a) is preferably obtained by grafting at least one of the α,β-unsaturated carboxylic acid and the acid anhydride thereof onto at least one of polyethylene, polypropylene, and propylene-α-olefin copolymer.

The acid-modified polyolefin resin (a) in the present invention is not particularly limited and is preferably an acid-modified propylene-α-olefin copolymer. The propylene-α-olefin copolymer consists mainly of propylene and copolymerized with α-olefin. One or several species of α-olefins such as ethylene, 1-butene, 1-heptene, 1-octene, and 4-methyl-1-pentene, are available. Among these α-olefins, ethylene and 1-butene are preferable. The ratio of the propylene component to the α-olefin component in the propylene-α-olefin copolymer is not particularly limited. The propylene component in the propylene-α-olefin copolymer is preferably 50 mol% or more, and more preferably 70 mol% or more. The acid-modified polyolefin resin (a) may or may not have a copolymerization component derived from monomers other than α-olefin, such as vinyl acetate.

Examples of at least one of α,β-unsaturated carboxylic acid and the acid anhydride thereof include maleic acid, itaconic acid, citraconic acid, and acid anhydride thereof. Among them, an acid anhydride is preferable, and maleic anhydride is more preferable. Therefore, the acid-modified polyolefin resin (a) may specifically be a maleic anhydride-modified polypropylene, a maleic anhydride-modified propylene-ethylene copolymer, a maleic anhydride-modified propylene-butene copolymer, or a maleic anhydride-modified propylene-ethylene-butene copolymer. These maleic anhydride-modified polyolefins may be used alone or in combination of two or more.

The acid-modified polyolefin resin (a) has an acid value of preferably 5 mgKOH/g or more, more preferably 6 mgKOH/g or more, further preferably 7 mgKOH/g or more, and particularly preferably 10 mgKOH/g or more, as a lower limit, from the viewpoint of solder heat resistance and adhesiveness to a resin substrate and a metal substrate. An acid value equal to or greater than the lower limit may increase reactivity with a curing agent (b), resulting in high adhesive strength. Additionally, a crosslinking density may be increased, resulting in excellent solder heat resistance. The acid value is preferably 30 mgKOH/g or less, more preferably 28 mgKOH/g or less, and further preferably 25 mgKOH/g or less. as an upper limit. An acid value equal to or less than the upper limit can improve adhesiveness. In addition, solution viscosity and its stability over time can be improved, resulting in excellent pot life. Further, thickening over time can be reduced in the coating process of the adhesive composition on a substrate, leading to increased production efficiency of a laminate.

The acid-modified polyolefin resin (a) has a number average molecular weight (Mn) of preferably from 10,000 to 50,000, more preferably from 15,000 to 45,000, further preferably from 20,000 to 40,000, and particularly preferably from 22,000 to 38,000. A number average molecular weight equal to or greater than the lower limit may lead to an increase in cohesive force, resulting in high adhesiveness. The number average molecular weight equal to or less than the upper limit may lead to an increase in fluidity, resulting in excellent handleability.

The acid-modified polyolefin resin (a) is preferably crystalline. A sample of the acid-modified polyolefin is melted by heating at a rate of 20°C/min, rapidly cooled to the temperature of liquid nitrogen, and melted by reheating at a rate of 20°C/min, with a differential scanning calorimeter. The peak temperature of the obtained melting curve was determined as a melting point. An acid-modified polyolefin that exhibits a distinct melting peak during reheating is classified as crystalline, while an acid-modified polyolefin that does not exhibit a distinct melting peak is classified as amorphous.

The acid-modified polyolefin resin (a) has a melting point (Tm) preferably ranging from 50°C to 120°C, more preferably from 60°C to 100°C, and most preferably from 70°C to 90°C. A melting point equal to or greater than the lower limit may lead an increase in cohesive force inherent to crystals, resulting in enhanced adhesiveness and solder heat resistance. A melting point equal to or less than the upper limit may lead an increase in solution stability, flexibility, and good handleability during adhesion.

The acid-modified polyolefin resin (a) has a heat of melting (ΔH) preferably ranging from 5 J/g to 60 J/g, more preferably from 10 J/g to 50 J/g, and most preferably from 20 J/g to 40 J/g. A heat of melting equal to or greater than the lower limit may lead an increase in cohesive force inherent to crystals, resulting in enhanced adhesiveness and solder heat resistance. A heat of melting equal to or less than the upper limit may lead an increase in solution stability, fluidity, and good handleability during adhesion.

A process for producing the acid-modified polyolefin resin (a) is not particularly limited. Examples of the process for producing the acid-modified polyolefin resin (a) include a radical grafting reaction, which comprises generating a radical for the polymer which becomes a main chain, and graft-polymerizing unsaturated carboxylic acids and acid anhydride thereof from the radical.

A radical initiator is not particularly limited, and an organic peroxide is preferable. The organic peroxide is not particularly limited, and examples of the organic peroxide include peroxides such as di-tert-butyl peroxyphthalate, tert-butyl hydroperoxide, dicumyl peroxide, benzoyl peroxide, tert-butyl peroxybenzoate, tert-butylperoxy-2-ethylhexanoate, tert-butyl peroxypivalate, methyl ethyl ketone peroxide, di-tert-butyl peroxide and lauroyl peroxide; and azonitriles such as azobisisobutyronitrile and azobisisopropionitrile.

### <Curing agent (b)>

The adhesive composition in the present invention comprises a curing agent (b) (hereinafter merely referred to as component (b) in some cases). The curing agent (b) in the adhesive composition allows for increases in adhesiveness and solder heat resistance. Conventional curing agent can be used as a curing agent (b). Examples of the curing agent (b) include an epoxy resin, a polyisocyanate, a polycarbodiimide, an oxazoline crosslinker, and an aziridine crosslinker. Among them, an epoxy resin, a polyisocyanate, and a polycarbodiimide are preferred. These crosslinkers may be used alone or in combination of two or more.

### <Epoxy resin>

The epoxy resin in the present invention is not particularly limited as long as the epoxy resin has an epoxy group in a molecule. An epoxy resin having 2 or more epoxy groups is preferred. The epoxy resin is not particularly limited, and the epoxy resin is specifically exemplified by aromatic epoxy resins such as biphenyl type epoxy resin, naphthalene type epoxy resin, bisphenol A type epoxy resin, bisphenol F type epoxy resin, novolak type epoxy resin; alicyclic epoxy resins such as dicyclopentadiene type epoxy resin; amino group-containing epoxy resins such as tetraglycidyl diaminodiphenylmethane, triglycidyl p-aminophenol, tetraglycidyl bisaminomethyl cyclohexanone, N,N,N' ,N' -tetraglycidyl-m-xylenediamine; and aliphatic epoxy resins such as epoxy-modified polybutadiene. These may be used alone or in combination of two or more. Among them, the aromatic epoxy resin, the alicyclic epoxy resin, and the amino group-containing epoxy resin are preferable, and the amino group-containing epoxy resin are more preferable due to increase of solder heat resistance. Among the aromatic epoxy resins, the biphenyl type epoxy resin and the novolak type epoxy resin are preferable, and the novolak type epoxy resin is more preferable. Among the alicyclic epoxy resins, the dicyclopentadiene type epoxy resin is preferable. These epoxy resins may be used in combination with another curing agent exemplified by a polyisocyanate and a polycarbodiimide.

The epoxy resin in the present invention has an epoxy equivalent of preferably 50 g/eq or more, more preferably 70 g/eq or more, and further preferably 80 g/eq or more. The epoxy equivalent is preferably 400 g/eq or less, more preferably 350 g/eq or less, and further preferably 300 g/eq or less. Keeping the epoxy resin within the specified range could result in excellent heat resistance to solder.

### <Polycarbodiimide>

The polycarbodiimide in the present invention is not particularly limited as long as the polycarbodiimide has a carbodiimide group in a molecule. Preferred is a polycarbodiimide having 2 or more carbodiimide groups in a molecule.

The polycarbodiimide may be an aromatic carbodiimide compound, an alicyclic carbodiimide compound, or an aliphatic carbodiimide compound. These may be used alone or in combination of two or more. Examples of the aromatic carbodiimide compounds include poly(m-phenylene carbodiimide), poly(p-phenylene carbodiimide), poly(tolylene carbodiimide), poly(diisopropylphenylene carbodiimide), poly(methyldiisopropylphenylene carbodiimide), and poly(4,4'-diphenylmethane carbodiimide). Examples of the alicyclic carbodiimide compound include poly(m-cyclohexyl carbodiimide), poly(p-cyclohexyl carbodiimide), poly(4,4'-di cyclohexylmethane carbodiimide), and poly(3,3'-dicyclohexylmethane carbodiimide). The aliphatic carbodiimide compound may be either a linear or a branched aliphatic carbodiimide compound. Preferred is a linear aliphatic carbodiimide compound, and the linear aliphatic carbodiimide compound is specifically exemplified by polymethylene carbodiimide, polyethylene carbodiimide, polypropylene carbodiimide, polybutylene carbodiimide, polypentamethylene carbodiimide, and polyhexamethylene carbodiimide. These may be used alone or in combination of two or more. Among them, aromatic carbodiimide compounds and alicyclic carbodiimide compounds are preferred.

### <Polyisocyanate>

The polyisocyanate in the present invention is preferably a polyfunctional isocyanate compound having 2 or more isocyanate groups in a molecule. The polyisocyanate also includes a compound derived from the polyfunctional isocyanate compound.

The polyisocyanate may be an aromatic isocyanate compound, an alicyclic isocyanate compound, or an aliphatic isocyanate compound. These may be used alone or in combination of two or more. Among them, aliphatic isocyanate compound is preferable, and aliphatic diisocyanate compound is more preferable. Examples of the aromatic isocyanate compound include 2,4-tolylene diisocyanate, 2,6-tolylene diisocyanate, 1,3-xylylene diisocyanate, 1,4-naphthalene diisocyanate, 1,5-naphthalene diisocyanate, 1,8-naphthalene diisocyanate, 3,3'-biphenyl diisocyanate, 4,4'-biphenyl diisocyanate, 3,3'-dimethyl-4,4'-biphenyl diisocyanate, diphenylmethane-3,3'-diisocyanate, diphenylmethane-4,4'-diisocyanate, and 3,3' -dimethyldiphenylmethane-4,4' -diisocyanate. These may be used alone or in combination of two or more. Among them, 3,3' -dimethyl-4,4' -biphenyl diisocyanate is preferable. Examples of the alicyclic isocyanate compound include isophorone diisocyanate, norbornene diisocyanate, 1,2-cyclohexane diisocyanate, 1,3-cyclohexane diisocyanate, 1,4-cyclohexane diisocyanate, and dicyclohexylmethane 4,4'-diisocyanate. These may be used alone or in combination of two or more. The aliphatic isocyanate compound may be either a linear or a branched aliphatic isocyanate compound. Preferred is a linear aliphatic diisocyanate compound, and such aliphatic isocyanate compound is specifically exemplified by 1,3-propane diisocyanate, 1,4-tetramethylene diisocyanate, 1,5-pentamethylene diisocyanate, 1,6-hexamethylene diisocyanate, 1,7-heptamethylene diisocyanate, 1,8-octamethylene diisocyanate, and 1,9-nonamethylene diisocyanate. These may be used alone or in combination of two or more. Among them, preferred is 1,6-hexamethylene diisocyanate.

The polyisocyanate may be an isocyanurate, an adduct, a biuret, an uretdione, or an allophanate of the above isocyanate compounds. The polyisocyanate may be a blocked isocyanate in which isocyanate groups are blocked. These compounds may be used alone or in combination of two or more. Among them, an isocyanurate or a biuret are preferred.

The adhesive composition of the present invention comprises the curing agent (b) in an amount of preferably 0.5 parts by mass or more, more preferably 1 part by mass or more, further preferably 5 parts by mass or more, and particularly preferably 10 parts by mass or more with respect to 100 parts by mass of the acid-modified polyolefin (a). The curing agent (b) in an amount equal to or greater than the lower limit may lead to sufficient curing effects, resulting in high adhesiveness and excellent solder heat resistance. The amount is preferably 60 parts by mass or less, more preferably 50 parts by mass or less, and further preferably 40 parts by mass or less. The curing agent (b) in an amount equal to or less than the upper limit may allow the adhesive composition to have enhanced low dielectric properties and enhanced insulation reliability. Namely, by adjusting the amount of the curing agent (b) within the above range, the adhesive composition can have low dielectric properties and enhanced insulation reliability as well as adhesiveness, solder heat resistance, and pot life.

A preferred example of the phosphorus flame retardant (c) is a flame retardant containing a compound represented by Formula (1). The flame retardant (c) is preferably a flame retardant containing one or two or more selected from the group consisting of compounds represented by Formula (2), Formula (3), Formula (4), and Formula (5). As the phosphorus flame retardant (c), a flame retardant containing tetrakis(2,6-dimethylphenyl)=(3,3,5-trimethylcyclohexane-1,1-diyl)bis(4,1-phenylene)=bisphosphate corresponding to a compound represented by Formula (2), is more preferable due to availability.

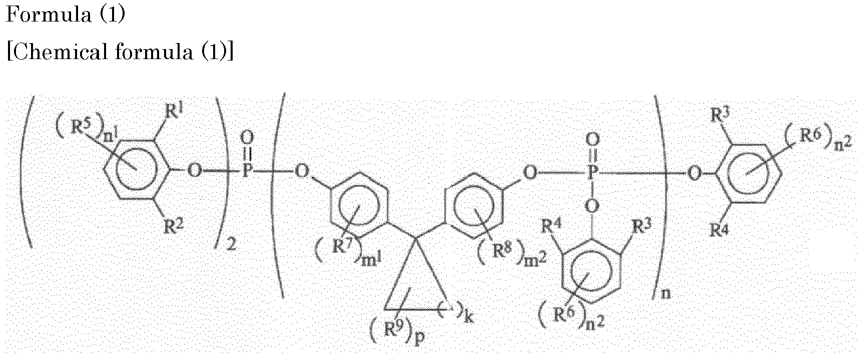

In the formula, R¹, R², R³, and R⁴ each independently represents a hydrogen atom, a C₁₋₄ alkyl group, or a C₁₋₄ alkoxy group; R⁵, R⁶, and R⁹ each independently represents a C₁₋₁₀ alkyl group or a C₁₋₁₀ alkoxy group; R⁷ and R⁸ each independently represents a C₁₋₄ alkyl group or a C₁₋₄ alkoxy group; n represents an integer of from 1 to 10; n¹ and n² each independently represents an integer of from 0 to 3; m¹ and m² each independently represents an integer of from 0 to 4; p represents an integer of from 0 to 26; k represents an integer of from 3 to 12; when p is 2 or greater, any two R⁹s can be bound to form another ring together with carbon atoms connecting to the R⁹s.

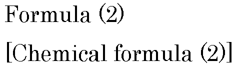

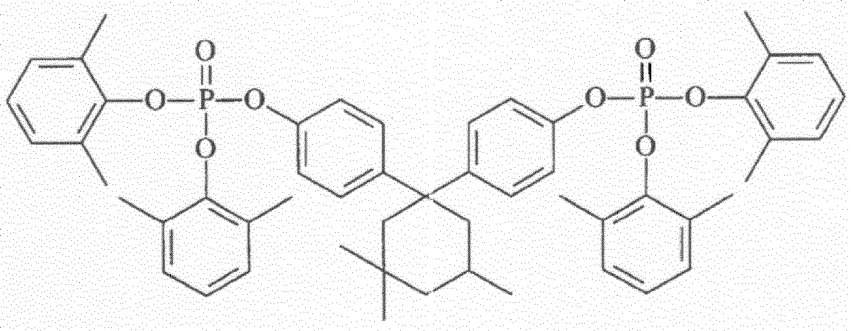

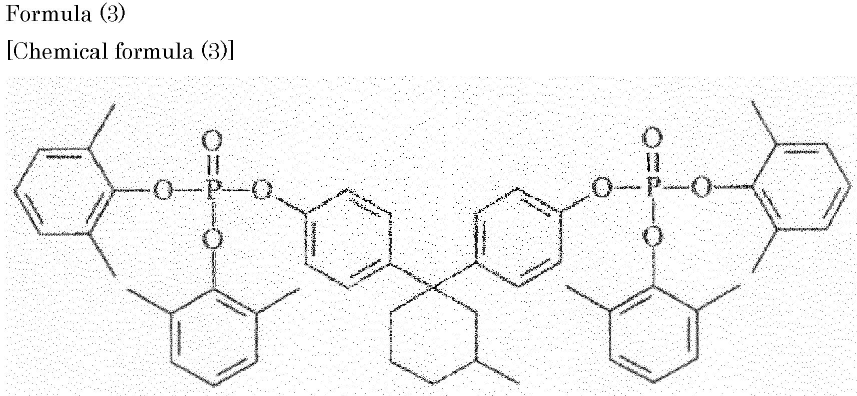

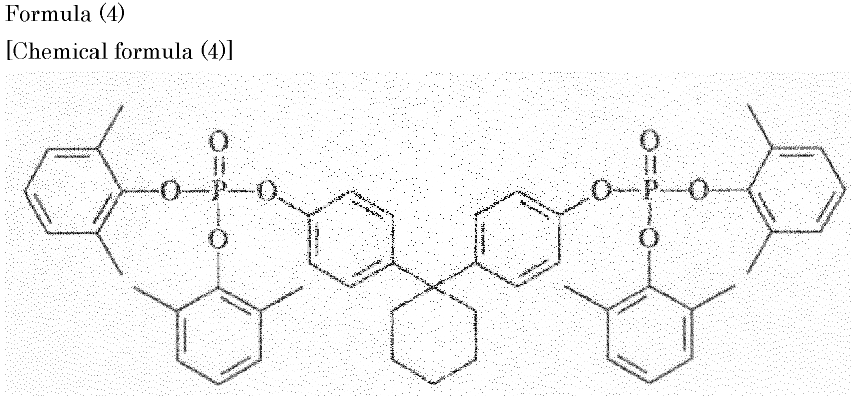

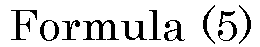

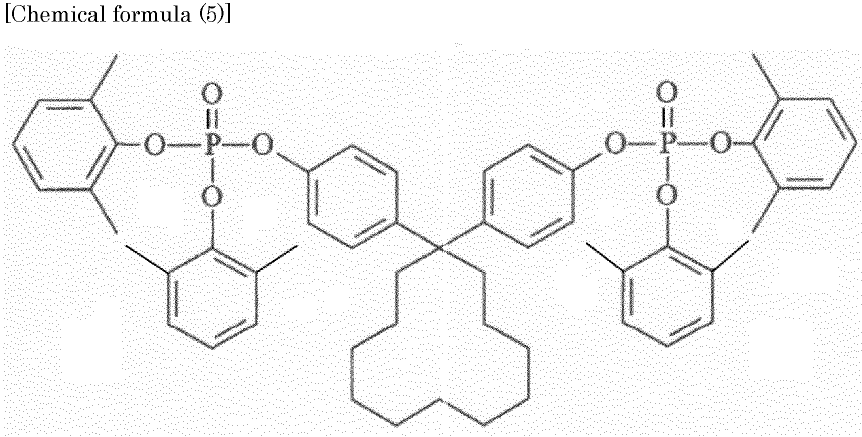

### <Phosphorus flame retardant (c)>

The adhesive composition of the present invention comprises a phosphorus flame retardant (c) (hereinafter merely referred to as a component (c) in some cases). The phosphorus flame retardant (c) of the present invention contains an alicyclic structure in a molecule. The phosphorus flame retardant (c) with the alicyclic structure reduces hygroscopicity and suppresses the generation of phosphoric acid caused by hydrolysis of the phosphorus flame retardant (c). This prevents electrochemical migration, ensuring insulation reliability.

The phosphorus flame retardant (c) is preferably amorphous. A sample of the phosphorus flame retardant is heated at a rate of 20°C/min with a differential scanning calorimeter, and a phosphorus flame retardant that shows a distinct melting peak during heating is classified as crystalline, while a phosphorus flame retardant that does not show a distinct melting peak is classified as amorphous. An amorphous phosphorus flame retardant (c) has high compatibility with the acid-modified polyolefin (a), leading to an increase in adhesiveness of the adhesive composition. The phosphorus flame retardant (c) has a molecular weight of preferably 1000 or less, and more preferably 900 or less to improve compatibility with other components in the adhesive composition.

The phosphorus flame retardant (c) preferably has higher concentration of phosphorus atoms (% by mass) in a molecule to obtain a cured product having high flame retardance. The concentration of phosphorus atoms (% by mass) in a molecule of the phosphorus flame retardant (c) is preferably 1% by mass or more, more preferably 2% by mass or more, further preferably 3% by mass or more, and particularly preferably 5% by mass or more. The upper limit is not particularly limited, and is, for example, 30% by mass or less, 25% by mass or less, or 20% by mass or less.

The phosphorus flame retardant (c) preferably contains higher numbers of aryl group (aromatic ring) in a molecule to produce a cured product with high heat-resisting property. The number of aryl group in the phosphorus flame retardant (c) is preferably 1 or more, more preferably 2 or more, further preferably 5 or more, and particularly preferably 6 or more. The upper limit is not particularly limited, and is, for example, 20 or less, 15 or less, or 10 or less. The phosphorus flame retardant (c) with higher concentration of phosphorus atoms (% by mass) in a molecule and a greater number of aryl group in a molecule is preferred to produce a cured product having both of high flame retardance and high heat-resisting property. However, as the number of aryl group increases, the molecular weight increases, resulting in relatively low concentration of phosphorus atoms (% by mass) in a molecule. Therefore, it is particularly desirable for the phosphorus flame retardant (c) to have the concentration of phosphorus atoms of 5% by mass or more in a molecule is and the number of aryl group of 6 or more in a molecule.

In addition, the aromatic ring is preferably located in the vicinity of the phosphorus atom of the phosphorus flame retardant (c) from the viewpoint of hydrolysis resistance. When the phosphorus flame retardant (c) is hydrolyzed, phosphoric acid is generated and thus copper is leached from a circuit board, resulting in deterioration of insulation reliability. The presence of a group capable of causing significant steric hindrance in the vicinity of the phosphorus atom may decrease the generation of phosphoric acid, which is caused by hydrolysis of the phosphorus flame retardant (c) under high-temperature and humid conditions; this leads to an increase in insulation reliability. Specifically, the aromatic ring is preferably bonded to the phosphorus atom through a phosphoric acid ester bond. Additionally, for further enhancing the steric hindrance effect, the aromatic ring preferably has substituents such as alkyl groups.

The adhesive composition comprises the phosphorus flame retardant (c) in an amount preferably ranging from 1 to 60 parts by mass, more preferably from 3 to 55 parts by mass, and further preferably from 5 to 50 parts by mass with respect to 100 parts by mass of the total amount of the components (a) and (b). Such an amount of the phosphorus flame retardant (c) in the adhesive composition may lead to high adhesiveness, excellent solder heat resistance, excellent electrical properties, high insulation reliability, and high flame retardance of the adhesive composition.

### <Adhesive composition>

The adhesive composition of the present invention comprises the above components (a) to (c) and ensures high adhesiveness to low-polarity resin substrates such as liquid crystal polymer (LCP) and metal substrates, excellent electrical properties (low dielectric properties), excellent solder heat resistance, high insulation reliability, and high flame retardance. Consequently, an adhesive coating (adhesive layer) formed by applying the adhesive composition to the substrate and allowing it to cure can have excellent low dielectric properties, excellent solder heat resistance, high insulation reliability, and high flame retardance.

The adhesive composition of the present invention may further contain an organic solvent. The organic solvent contained in the adhesive composition of the present invention is not particularly limited as long as the solvent can dissolve the acid-modified polyolefin (a), the curing agent (b), and the phosphorus flame retardant (c). Specifically, examples of the organic solvent include aromatic hydrocarbons such as benzene, toluene, and xylene; aliphatic hydrocarbons such as hexane, heptane, octane, and decane; alicyclic hydrocarbons such as cyclohexane, cyclohexene, methylcyclohexane, and ethylcyclohexane; halogenated hydrocarbons such as trichloroethylene, dichloroethylene, chlorobenzene, and chloroform; alcoholic solvents such as methanol, ethanol, isopropyl alcohol, butanol, pentanol, hexanol, propanediol and phenol; ketone-type solvents such as acetone, methyl isobutyl ketone, methyl ethyl ketone, pentanone, hexanone, cyclohexanone, isophorone, and acetophenone; cellosolves such as methyl cellosolve and ethyl cellosolve; ester-type solvents such as methyl acetate, ethyl acetate, butyl acetate, methyl propionate, and butyl formate; and glycol ether-type solvents such as ethylene glycol mono-n-butyl ether, ethylene glycol mono-isobutyl ether, ethylene glycol mono-tert-butyl ether, diethylene glycol mono-n-butyl ether, diethylene glycol mono-isobutyl ether, triethylene glycol mono-n-butyl ether, and tetraethylene glycol mono-n-butyl ether. These may be used alone or in combination of two or more. Particularly, from the viewpoint of work environment and drying properties, methylcyclohexane and toluene are preferred.

The amount of the organic solvent preferably ranges from 100 to 1000 parts by mass, more preferably from 200 to 900 parts by mass, and most preferably from 300 to 800 parts by mass with respect to 100 parts by mass of the acid-modified polyolefin (a). The organic solvent in an amount equal to or greater than the lower limit may improve fluidity and pot life. In addition, the organic solvent in an amount equal to or less than the upper limit may lead to advantages in production cost and transportation cost.

The adhesive composition of the present invention has a relative permittivity (εc) at a frequency of 10 GHz of preferably 3.0 or less, more preferably 2.6 or less, and further preferably 2.3 or less. Although the lower limit is not particularly limited, the lower limit is practically 2.0. The adhesive composition has a relative permittivity (εc) at the entire frequency ranging from 1 GHz to 60 GHz of preferably 3.0 or less, more preferably 2.6 or less, and further preferably 2.3 or less.

The adhesive composition of the present invention has a dielectric dissipation factor (tanδ) at a frequency of 10 GHz of preferably 0.02 or less, more preferably 0.01 or less, and furthermore preferably 0.008 or less. Although the lower limit is not particularly limited, the lower limit is practically 0.0001. The adhesive composition has a dielectric dissipation factor (tanδ) at the entire frequency ranging from 1 GHz to 60 GHz of preferably 0.02 or less, more preferably 0.01 or less, and further preferably 0.008 or less.

In the present invention, the relative permittivity (εc) and the dielectric dissipation factor (tanδ) can be measured as follows. The adhesive composition is applied to a release substrate so as to have a thickness of 25 µm when dried, and dried at approximately 130°C for about 3 minutes. Subsequently, the adhesive composition on the release substrate is cured through heat treatment at approximately 140°C for about 4 hours, and the cured adhesive composition layer (adhesive layer) is detached from a release film to measure a relative permittivity (εc) at a frequency of 10 GHz. Specifically, the relative permittivity (εc) and the dielectric dissipation factor (tanδ) can be determined from measurement by a cavity resonator perturbation method.

The adhesive composition of the present invention may further contain other components, if needed, to the extent that the components do not impair the effects of the present invention. Specific examples of the components include an oligo-phenylene ether, an inorganic filler, a tackifier, and a silane coupling agent.

### <Oligo-phenylene ether>

The oligo-phenylene ether in the present invention is a compound with a repeating unit of a phenylene ether structure. The oligo-phenylene ether may be a compound with a structural unit preferably represented by Formula (6) and/or Formula (7).

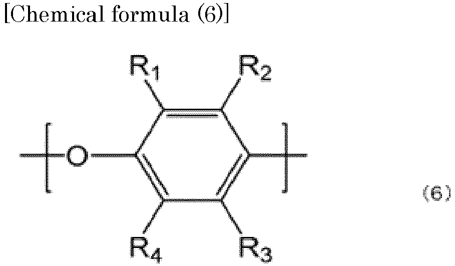

In Formula (6), preferably, R₁, R₂, R₃, and R₄ each independently represents a hydrogen atom, an optionally substituted alkyl group, an optionally substituted alkenyl group, an optionally substituted alkynyl group, an optionally substituted aryl group, an optionally substituted aralkyl group, or an optionally substituted alkoxy group. The "alkyl group" in the optionally substituted alkyl group may be a linear or a branched alkyl group having carbon atoms of 1 or more and 6 or less, and preferably 1 or more and 3 or less. Specifically, the alkyl group is preferably a methyl group, an ethyl group, a propyl group, an isopropyl group, a butyl group, an isobutyl group, a sec-butyl group, a tert-butyl group, a pentyl group, or a hexyl group, and more preferably a methyl group or an ethyl group. Examples of the "alkenyl group" in the optionally substituted alkenyl group include an ethenyl group, 1-propenyl group, 2-propenyl group, 3-butenyl group, pentenyl group, and hexenyl group, and ethenyl group and 1-propenyl group are preferable. Examples of the "alkynyl group" in the optionally substituted alkynyl group include an ethynyl group, a 1-propynyl group, a 2-propynyl (propargyl) group, a 3-butynyl group, a pentynyl group, and a hexynyl group, and more preferably an ethenyl group, a 1-propynyl group, or a 2-propynyl (propargyl) group. Examples of the "aryl group" in the optionally substituted aryl group include a phenyl group and a naphthyl group, and more preferably a phenyl group. Examples of the "aralkyl group" in the optionally substituted aralkyl group include a benzyl group, a phenethyl group, a 2-methylbenzyl group, a 4-methylbenzyl group, an α-methylbenzyl group, a 2-vinylphenethyl group, and a 4-vinylphenethyl group, and more preferably a benzyl group. The "alkoxy group" in the optionally substituted alkoxy group may be a linear or a branched alkoxy group having carbon atoms of 1 or more and 6 or less, and preferably 1 or more and 3 or less. The alkoxy group is, for example, a methoxy group, an ethoxy group, a propoxy group, an isopropoxy group, a butoxy group, a sec-butoxy group, a tert-butoxy group, a pentyloxy group, or a hexyloxy group, and more preferably a methoxy group or an ethoxy group. If the alkyl group, aryl group, alkenyl group, alkynyl group, aralkyl group, and alkoxy group are substituted, each may have one or two or more substituents. Examples of such substituents include halogen atoms such as fluorine atom, chlorine atom, and bromine atom; C₁₋₆ alkyl groups such as a methyl group, an ethyl group, a propyl group, an isopropyl group, a butyl group, an isobutyl group, a sec-butyl group, a tert-butyl group, a pentyl group, and a hexyl group; aryl groups such as a phenyl group and a naphthyl group; alkenyl groups such as an ethenyl group, a 1-propenyl group, and a 2-propenyl group; alkynyl groups such as an ethynyl group, a 1-propynyl group, and a 2-propynyl group; aralkyl groups such as a benzyl group and a phenethyl group; and alkoxy groups such as a methoxy group and an ethoxy group. It is preferred that R₁ and R₄ each represent methyl groups and R₂ and R₃ each represent hydrogen atoms.

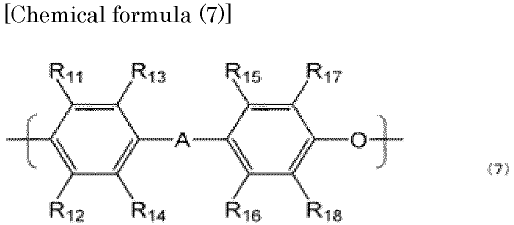

**In** Formula (7), preferably, R₁₁, R₁₂, R₁₃, R₁₄, R₁₅, R₁₆, R₁₇, and R₁₈ each independently represents a hydrogen atom, an optionally substituted alkyl group, an optionally substituted alkenyl group, an optionally substituted alkynyl group, an optionally substituted aryl group, an optionally substituted aralkyl group, or an optionally substituted alkoxy group. Each of the substituents are defined as described above. The alkyl group is preferably a methyl group, an ethyl group, a propyl group, an isopropyl group, a butyl group, an isobutyl group, a sec-butyl group, a tert-butyl group, a pentyl group, or a hexyl group, and preferably a methyl group. It is preferred that R₁₃, R₁₄, R₁₇, and R₁₈ each represent methyl groups and R₁₁, R₁₂, R₁₅, and R₁₆ each represent hydrogen atoms. **In** addition, "-A-" is preferably a linear, a branched, or a cyclic divalent hydrocarbon group having 20 or less of carbon atoms, or an oxygen atom. The number of the carbon atoms of "A" is more preferably 1 or more and 15 or less, and further preferably 2 or more and 10 or less. A divalent hydrocarbon group of "A" is exemplified by a methylene group, an ethylene group, a n-propylene group, a n-butylene group, a cyclohexylene group, and a phenylene group, and preferably a phenylene group. Particularly, A is preferably an oxygen atom.

The oligo-phenylene ether may be a modified polyphenylene ether functionalized by partially or wholly substitution with ethylenically unsaturated groups such as methacrylic group and vinylbenzyl group, epoxy group, amino group, hydroxy group, mercapto group, carboxy group, and silyl group. Further, the oligo-phenylene ether preferably has hydroxyl groups, epoxy groups, or ethylenically unsaturated groups at both terminals to improve solder heat resistance. Examples of the ethylenically unsaturated group include alkenyl groups such as ethenyl group, allyl group, methacrylic group, propenyl group, butenyl group, hexenyl group, and octenyl group; cycloalkenyl groups such as cyclopentenyl group and cyclohexenyl group; and alkenylaryl groups such as vinylbenzyl group and vinylnaphthyl group. The oligo-phenylene ether may have the same or different substituents at both terminals. In order to control the balance between low-dielectric dissipation factor and lowering of resin residue, the oligo-phenylene ether preferably has hydroxy groups, methacrylic groups, or vinylbenzyl groups at both terminals.

Particularly preferably, a compound having a repeating unit represented by Formula (6) or Formula (7) is a compound represented by Formula (8).

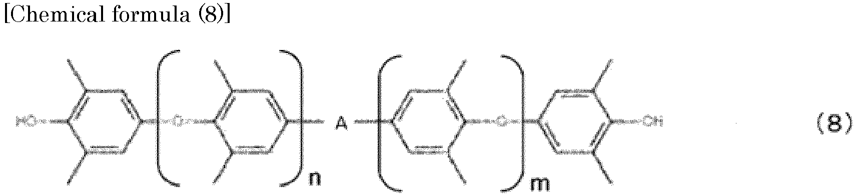

In Formula (8), n is preferably 2 or more, and more preferably 3 or more. n is preferably 12 or less, more preferably 11 or less, and further preferably 10 or less. In Formula (8), m is preferably 2 or more, and more preferably 3 or more. m is preferably 12 or less, more preferably 11 or less, and further preferably 10 or less. -A- represents the same as -A- in Formula (7).

Particularly preferably, a compound having structural units represented by Formula (6) or Formula (7) is a compound represented by Formula (9) or Formula (10).

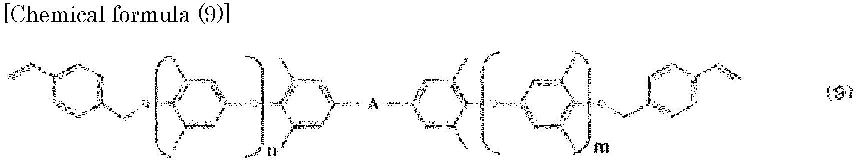

In Formula (9), n is preferably 2 or more, and more preferably 3 or more. n is preferably 12 or less, more preferably 11 or less, and further preferably 10 or less. In Formula (9), m is preferably 2 or more, and more preferably 3 or more. m is preferably 12 or less, more preferably 11 or less, and further preferably 10 or less. -A- represents the same as -A- in Formula (7).

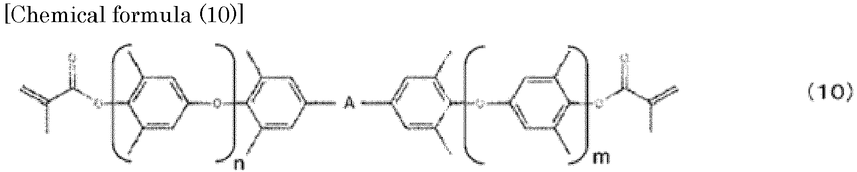

In Formula (10), n is preferably 2 or more, and more preferably 3 or more. n is preferably 12 or less, more preferably 11 or less, and further preferably 10 or less. In Formula (10), m is preferably 2 or more, and more preferably 3 or more. m is preferably 12 or less, more preferably 11 or less, and further preferably 10 or less. -A- represents the same as -A- in Formula (7).

The oligo-phenylene ether has a number average molecular weight of preferably 3000 or less, more preferably 2700 or less, and further preferably 2500 or less. The number average molecular weight of the oligo-phenylene ether is preferably 500 or more and more preferably 700 or more. A number average molecular weight of the oligo-phenylene ether equal to or greater than the lower limit may lead to enhanced flexibility of an adhesive layer. A number average molecular weight of the oligo-phenylene ether equal to or less than the upper limit may lead to enhanced solubility to an organic solvent.

The adhesive composition contains the oligo-phenylene ether in an amount of preferably 0.05 parts by mass or more, more preferably 1 part by mass or more, and further preferably 5 parts by mass or more with respect to 100 parts by mass of the component (a). The oligo-phenylene ether in an amount equal to or greater than the lower limit may lead to excellent solder heat resistance. The amount is preferably 200 parts by mass or less, more preferably 150 parts by mass or less, further preferably 100 parts by mass or less, and particularly preferably 50 parts by mass or less. The oligo-phenylene ether in an amount equal to less than the upper limit may lead to high adhesiveness and excellent solder heat resistance.

### <Inorganic filler>

The adhesive composition of the present invention may contain an inorganic filler, if needed, as long as the effect of the invention is not impaired. The inorganic filler can improve solder heat resistance of a laminate made from the adhesive composition. The inorganic filler is preferably a filler, and more preferably a silica filler (hereinafter merely referred to as silica in some cases). Silica is significantly preferred due to its ability to improve solder heat resistance. Generally, silica is known as hydrophobic silica and hydrophilic silica. The hydrophobic silica include silica treated with, for example, dimethyldichlorosilane, hexamethyldisilazane, or octylsilane. The hydrophobic silica can impart moisture absorption resistance to the adhesive composition. The hydrophilic silica, on the other hand, include silica obtained without any treatment and has a silanol group or siloxane on its surface.

The inorganic filler has an average particle size of preferably from 0.01 to 10 µm, more preferably 0.02 to 5 µm, and further preferably 0.1 to 1 µm. The average particle size (median diameter) can be measured on a volume basis by a laser diffraction and scattering particle size distribution analyzer.

The adhesive composition of the present invention contains the inorganic filler in an amount ranging preferably from 2 to 50 parts by mass, more preferably 3 to 45 parts by mass, and further preferably 5 to 40 parts by mass with respect to 100 parts by mass of the total amount of the components (a) to (c). The amount of the inorganic filler within this range may lead to high adhesiveness, excellent solder heat resistance, and excellent electrical properties of the adhesive composition.

### <Tackifier>

The adhesive composition of the present invention may contain a tackifier, if needed, as long as the effect of the invention is not impaired. The tackifier is contained for enhancing adhesive strength, and is exemplified by polyterpene resin, rosin-type resin, aliphatic petroleum resin, alicyclic petroleum resin, copolymerized petroleum resin, styrene resin and hydrogenated petroleum resin. These may be used alone or in combination of two or more. When the adhesive composition of the present invention contains the tackifier, the amount of the tackifier is preferably 1 to 200 parts by mass, more preferably 5 to 150 parts by mass, and most preferably 10 to 100 parts by mass with respect to 100 parts by mass of the total amount of the components (a) to (c). The tackifier contained in an amount equal to or greater than the lower limit can sufficiently work. The tackifier contained in an amount equal to or less than the upper limit can prevent lowering of adhesiveness, solder heat resistance, and electrical properties.

### <Silane coupling agent>

The adhesive composition of the present invention may contain a silane coupling agent, if needed, as long as the effect of the invention is not impaired. The silane coupling agent is highly preferred for its ability to improve adhesiveness to metal and solder heat resistance. The silane coupling agent is not particularly limited and is exemplified by a silane coupling agent having an unsaturated group, a glycidyl group, or an amino group. Among them, the preferred is a silane coupling agent having a glycidyl group such as γ-glycidoxypropyltrimethoxysilane, β-(3,4-epoxycyclohexyl)ethyltrimethoxysilane, and β-(3,4-epoxycyclohexyl)ethyltriethoxysilane to improve solder heat resistance. When the adhesive composition contains the silane coupling agent, the amount of the silane coupling agent is preferably from 0.5 to 20 parts by mass with respect to 100 parts by mass of the total amount of the components (a) to (c). The amount of the silane coupling agent of 0.5 parts by mass or more may lead to an increase in solder heat resistance, and the amount of 20 parts by mass or less may lead to an increase in solder heat resistance and adhesiveness.

### <Laminate>

The laminate of the present invention includes two-layered laminate of "substrate/adhesive layer" where the adhesive composition is applied to a substrate, and a three-layered laminate of "substrate/adhesive layer/substrate" where an additional substrate is laminated on the adhesive composition of the two-layered laminate. The adhesive layer indicates a layer of the adhesive composition obtained by applying the adhesive composition of the present invention to a substrate and drying it. The laminate of the present invention can be obtained in a conventional manner by applying the adhesive composition of the present invention on various substrates, drying the adhesive composition, and optionally laminating another substrate.

### <Substrate>

The substrate is not particularly limited as long as the adhesive composition of the present invention can be applied to the substrate and dried to form an adhesive layer. Examples of the substrate include resin substrates such as filmy resin, metal substrates such as metal plate and metal foil, and paper.

Examples of a raw material of the resin substrate include polyester resin, polyamide resin, polyimide resin, polyamideimide resin, liquid crystal polymer, polyphenylene sulfide, syndiotactic polystyrene, polyolefin resin, and fluorine resin. Preferred is a substrate made of filmy resin (hereinafter referred to as a substrate film layer in some cases).

The metal substrate may be any conventionally known conductive material available for a circuit board. Examples of the material include metals such as SUS, copper, aluminum, iron, steel, zinc and nickel; alloys thereof; plated products thereof; and metals thereof treated with other metals such as zinc and chromium compound. Preferred is a metal foil, and more preferred is a copper foil. The thickness of the metal foil is not particularly limited, and the thickness is preferably 1 µm or more, more preferably 3 µm or more, and further preferably 10 µm or more. The thickness is preferably 50 µm or less, more preferably 30 µm or less, and further preferably 20 µm or less. If the metal foil is too thin, a circuit may not have sufficient electrical properties. Conversely, if the metal foil is too thick, processing efficiency during circuit preparation may be decreased. Metal foil is usually provided in a roll shape. The metal foil for producing the printed circuit board of the present invention may have any shape. In the case of a ribbon-shaped metal foil, the length and the width of the metal foil are not particularly limited. The width is preferably from around 250 to 500 cm.

Examples of the paper include woodfree paper, kraft paper, rolled paper and glassine paper. A composite material is exemplified by a glass epoxy.

Preferred materials for the substrate are, from the viewpoint of adhesive force to the adhesive composition and durability of the substrate itself and the laminate, polyester resin, polyamide resin, polyimide resin, polyamideimide resin, liquid crystal polymer, polyphenylene sulfide, syndiotactic polystyrene, polyolefin resin, fluorine resin, SUS steel sheet, copper foil, aluminum foil, or glass epoxy.

### <Adhesive sheet>

In the present invention, an adhesive sheet is a sheet comprising the laminate and a release substrate laminated by the adhesive composition. Specifically, the embodiments of the adhesive sheet include "laminate/adhesive layer/release substrate" and "release substrate/adhesive layer/laminate/adhesive layer/release substrate". The release substrate serves as a protective layer for the adhesive layer and the substrate. Furthermore, the release substrate can be removed from the adhesive sheet, enabling further transferring the adhesive layer onto another substrate.

The adhesive sheet of the present invention can be obtained in a conventional manner by applying the adhesive composition of the present invention on various laminate and drying the adhesive composition. After drying, when the release substrate is adhered to the obtained adhesive layer, the adhesive sheet can be wound up without set-off onto the substrate, resulting in excellent workability. That also enables stable preservation by protecting the adhesive layer, and easy use. Further, the adhesive composition can be adhered to a release substrate and then dried, and another release substrate can be adhered to the adhesive layer, if needed. The adhesion of the additional release substrate makes it possible for the adhesive layer itself to be transferred to another substrate.

### <Release substrate>

The release substrate is not particularly limited, and examples of the release substrate include the release substrate having paper such as woodfree paper, kraft paper, rolled paper, and glassine paper; a coating layers of a sealer such as clay, polyethylene and polypropylene provided on both sides of the paper; and a releasing agent such as silicone type, fluorine type, and alkyd type coated on each coating layer. The examples of the release substrate also include the release substrate having a film exemplified by various single olefin films such as polyethylene, polypropylene, ethylene-α-olefin copolymer and propylene-α-olefin copolymer or polyethylene terephthalate film; and the releasing agent coated on the film. The release substrate is preferably the release substrate having woodfree paper; a coating layers of polypropylene sealer provided on both sides of the woodfree paper; and an alkyd type releasing agent coated on each coating layer, or the release substrate having a polyethylene terephthalate film; and an alkyd type releasing agent coated on the film considering the releasing force between the release substrate and the adhesive layer and the negative effect of silicone on electrical properties.

In the present invention, the method for coating the adhesive composition on the substrate is not particularly limited. The adhesive composition may be applied to the substrate with, for example, a comma coater or a reverse roll coater. Alternatively, the adhesive layer may be provided by directly applying or transferring the adhesive layer to a rolled copper foil or a polyimide film, which are components of printed circuit board, if needed. The thickness of the adhesive layer when dried can be appropriately changed as needed, and the thickness preferably ranges from 5 to 200 µm. A thickness of the adhesive layer less than 5 µm results in insufficient adhesive strength. When a thickness of the adhesive layer is 200 µm or more, the drying of the adhesive layer tends to be insufficient, leading to an increase in solvent residue, which causes swelling in the pressing step in the production of printed circuit board. Drying conditions are not particularly limited, and a rate of solvent residue after drying is preferably 1% by mass or less. A rate of more than 1% by mass causes bubbling of the solvent residue in the pressing step in the production of the printed circuit board, causing swelling.

### <Printed circuit board>

"A printed circuit board" in the present invention comprises a laminate including a metal foil that forms a conductive circuit and a resin substrate, as constituent components. The printed circuit board is produced, for example, using a metal clad laminate by conventionally known methods such as subtractive method. The printed circuit board is a generic term that also includes so-called flexible printed circuits (FPCs), flat cables, and circuit boards for tape automated bonding (TAB), which are obtained by partially or fully covering a conductive circuit formed in a metal foil with a cover film or a screen-printing ink.

The printed circuit board of the present invention may have any layer structure applicable to a printed circuit board. The printed circuit board may be, for example, a printed circuit board having 4-layer structure of the substrate film layer, the metal foil layer, the adhesive layer, and the cover film layer or a 5-layer structure of the substrate film layer, the adhesive layer, the metal foil layer, the adhesive layer, and the cover film layer.

Further, 2 or 3 or more of the above printed circuit boards may be stacked, if necessary.

The adhesive composition of the present invention is suitable for each adhesive layer of the printed circuit board. Particularly, when the adhesive composition of the present invention is used as an adhesive, the adhesive can exhibit high adhesiveness to a low-polarity resin substrates such as LCP as well as conventional polyimide film, polyester film, and copper foil, which constitute a printed circuit board. That allows excellent solder heat resistance, and the adhesive layer can have low dielectric properties. Therefore, the adhesive composition of the present invention is preferable as an adhesive composition for a coverlay film, a laminated board, a copper foil with resin, and a bonding sheet.

The printed circuit board of the present invention may comprise, as a substrate film, any resin film which has been conventionally used as a substrate for a printed circuit board. Examples of the resin for the resin film include polyester resin, polyamide resin, polyimide resin, polyamideimide resin, liquid crystal polymer, polyphenylene sulfide, syndiotactic polystyrene, polyolefin resin, and fluorine resin. Particularly, the adhesive composition of the present invention exhibits high adhesiveness to low-polarity resin substrate such as liquid crystal polymer, polyphenylene sulfide, syndiotactic polystyrene, and polyolefin resin.

### <Cover film>

The cover film may be any insulating film conventionally known as an insulating film for a printed circuit board. Examples of the films may be the film made from the various polymers such as polyimide polyester, polyphenylene sulfide, polyethersulfone, polyetheretherketone, aramid, polycarbonate, polyarylate, polyamideimide, liquid crystal polymer, syndiotactic polystyrene, and polyolefin resin. The cover film is more preferably a polyimide film or a liquid crystal polymer film.

The printed circuit board of the present invention can be produced by any conventionally known process except for the use of the above mentioned materials for each layer.

In a preferred embodiment, a semifinished product having the adhesive layer on the cover film layer (hereinafter referred to as "a semifinished product on the cover film side") is produced. In addition, a semifinished product having a metal foil layer with a desired circuit pattern on the substrate film layer (hereinafter referred to as "a two-layer semifinished product on the substrate film side"), or a semifinished product having the adhesive layer on the substrate film layer and a metal foil layer with a desired circuit pattern on the adhesive layer (hereinafter referred to as "a three-layer semifinished product on the substrate film side") is produced. Hereinafter, these "two-layer semifinished product on the substrate film side" and "three-layer semifinished product on the substrate film side" are referred to as "a semifinished product on the substrate film side". The "semifinished product on the cover film side" and the "semifinished product on the substrate film side" can be laminated to form a four- or five-layered printed circuit board.

The "semifinished product on the substrate film side" is produced by a method including the steps of, for example, (A): coating the metal foil with a resin solution for the substrate film and primally drying the coating film, and (B): heat treating and drying a laminate of the metal foil and the primarily dried coating film obtained in the step (A). The step (B) may be referred to as "heating/solvent-removing step".

In order to form a circuit in a metal foil layer, a conventionally known method can be employed. The circuit may be formed by an additive method or a subtractive method, and preferably by a subtractive method.

The "semifinished product on the substrate film side" may be used to be directly adhered to the "semifinished product on the cover film side", or may be used to be adhered to the "semifinished product on the cover film side" after adhesion with the release film and storage.

The "semifinished product on the cover film side" can be produced, for example, by applying the adhesive to the cover film. If needed, a crosslinking reaction may be conducted in the applied adhesive. In a preferred embodiment, the adhesive layer is semi-cured.

The "semifinished product on the cover film side" may be used to be directly adhered to the "semifinished product on the substrate film side", or may be used to be adhered to the "semifinished product on the substrate film side" after adhesion with the release film and storage.

For example, the "semifinished product on the substrate film side" and the "semifinished product on the cover film side" are stored in the form of a roll, respectively, and then laminated together to form a printed circuit board. They can be laminated by any method. They can be laminated, for example, with a press machine or a roller. They can be laminated by heating with a hot press machine or a hot roller.

In case of a reinforcing material that is soft and capable of being wound up such as a polyimide film, a "semifinished product on the reinforcing material side" is, for example, preferably produced by applying the adhesive to the reinforcing material. Contrarily, in case of a reinforcing plate that is hard and incapable of being wound up such as metals such SUS and aluminum, and a glass fiber plate being hardened by epoxy resin, the "semifinished product on the reinforcing material side" is preferably produced by transferring the adhesive that is pre-coated on the release substrate. If needed, a crosslinking reaction may be conducted in the applied adhesive. In a preferred embodiment, the adhesive layer is semi-cured.

The "semifinished product on the reinforcing material side" may be used to be directly adhered to a back side of a printed circuit board, or may be used to be adhered to the "semifinished product on the substrate film side" after adhesion with the release film and storage.

All the "semifinished product on the substrate film side", the "semifinished product on the cover film side", and the "semifinished product on the reinforcing material side" are laminates for the printed circuit board in the present invention.

### <Electromagnetic wave shield film>

An electromagnetic wave shield film of the present invention comprises an adhesive layer and a protective layer. The adhesive layer is preferably formed from a conductive adhesive composition containing the adhesive composition of the present invention and conductive particles. In case where the adhesive layer is formed from the conductive adhesive composition, when the electromagnetic wave shield film of the present invention is disposed on a printed circuit board, the ground circuit of the printed circuit board and the conductive adhesive layer are brought into contact with each other to electrically connect the ground circuit and the conductive adhesive layer, thereby enabling electromagnetic shielding properties to be exhibited.

The conductive particles are not particularly limited, and may be metal fine particles, carbon particles, carbon nanotubes, carbon fibers, or metal fibers.

The electromagnetic wave shield film of the present invention may have a metal layer between the adhesive layer and the protective layer. The metal layer can function as a shield layer that absorbs and reflects electromagnetic waves, allowing the electromagnetic wave shield film of the present invention to have improved shielding properties.

### EXAMPLES

Hereinafter, the present invention will be further described in detail with Examples, however, the scope of the present invention is not limited by Examples. In Examples and in Comparative Examples, merely "part" means "part by mass".

### Methods for evaluating physical properties

### Acid value

The acid value (mgKOH/g) was a value determined by dissolving a resin sample in toluene and then titrating the obtained solution with a methanolic solution of sodium methoxide using phenolphthalein as an indicator.

### Number average molecular weight (Mn)

The number average molecular weight was determined by gel permeation chromatography (GPC).
Equipment: gel permeation chromatograph manufactured by Shimadzu Corporation
Standard substance: polystyrene resin
Mobile phase: tetrahydrofuran
Column: Shodex KF-802+KF-804L+KF-806L
Column temperature: 30°C
Flow rate: 1.0 ml/min
Detector: refractive index (RI) detector

### Measurement of melting point (Tm) and heat of melting (ΔH)

### 1. Acid-modified polyolefin

The melting point and the heat of melting was determined by melting a sample of the acid-modified polyolefin by heating up to 160°C at a rate of 20°C/min and then rapidly cooling it to the temperature of liquid nitrogen with a differential scanning calorimeter (DSC, type: Q-2000, manufactured by T. A. Instruments Japan). Subsequently, the sample was melted by reheating at a rate of 20°C/min. The melting point and the heat of melting were determined from the peak temperature and the area of the melting curve. An acid-modified polyolefin that exhibited a distinct melting peak in the reheating step was classified as crystalline while an acid-modified polyolefin without a distinct melting peak was classified as amorphous.

### 2. Phosphorus flame retardant

The melting point of the phosphorus flame retardant was determined from the peak temperature of the melting curve obtained by heating a phosphorus flame retardant at a rate of 20°C/min with a differential scanning calorimeter (DSC, type: Q-2000, manufactured by T. A. Instruments Japan). A phosphorus flame retardant that exhibited a distinct melting peak in the reheating step was classified as crystalline while a phosphorus flame retardant without a distinct melting peak was classified as amorphous.

### Method for evaluating physical characteristics of laminates, etc.

### (1) Peel strength (adhesiveness)

In order to determine a peel strength, the adhesive composition, which will be described later, was applied to a 12.5 µm thick polyimide film (Apical (registered trademark), manufactured by Kaneka) or a 25 µm thick LCP film (Vecstar (registered trademark), manufactured by Kuraray)) so that the adhesive composition would have a thickness of 25 µm when dried. The adhesive composition on the film was dried at 130°C for 3 minutes. Then, thus obtained adhesive film (B stage product) was adhered to an 18 µm thick rolled copper foil (BHY series, manufactured by JX Kinzoku) so that a glossy surface of the rolled copper foil could contact the adhesive layer. The rolled copper foil and the adhesive layer were adhered by pressing them at 160°C for 30 seconds under the pressure of 40 kgf/cm². The adhesive layer on the rolled copper foil was cured by heating at 140°C for 4 hours and a sample for measuring a peel strength was obtained. Subsequently, a 90° peel test was conducted at 25°C and a peel rate of the film of 50 mm/min. The results of this test show an adhesive strength at room temperature.

### <Evaluation criteria>

Excellent:1.2 N/mm or more
Good: 0.9 N/mm or more and less than 1.2 N/mm
Acceptable: 0. 6 N/mm or more and less than 0.9 N/mm
Unsatisfactory: less than 0.6 N/mm

### (2) Solder heat resistance

A sample was prepared by the same method as above. A test piece measuring 2.0 cm × 2.0 cm was subjected to an aging treatment at 23°C for 2 days. Subsequently, the aged sample was floated in a molten solder bath at 280°C for 10 seconds. The sample was then visually inspected for any changes in appearance such as swelling.

### <Evaluation criteria>

Excellent: no swelling and no discoloration
Good: partial swelling and no discoloration
Acceptable: full-surface swelling and no discoloration
Unsatisfactory: partial or full-surface swelling and discoloration

### (3) Relative permittivity (εc) and dielectric dissipation factor (tanδ)

An adhesive composition, which will be mentioned later, was applied to a 100 µm thick Teflon (registered trademark) sheet so that the adhesive composition would have a thickness of 25 µm when dried and cured. The adhesive composition on the Teflon sheet was dried at 130°C for 3 minutes. Subsequently, the adhesive composition on the Teflon sheet was heat treated at 140°C for 4 hours to complete the curing process. The adhesive resin sheet for test, obtained in this manner, was cut into a strip measuring 8 cm × 3 mm. The strip-shaped test piece was then measured by a cavity resonator perturbation method with a network analyzer (manufactured by ANRITSU CORPORATION) under conditions of 23°C and frequency of 10 GHz, to determine a relative permittivity (εc) and a dielectric dissipation factor (tanδ). The measurement results for the relative permittivity and the dielectric dissipation factor were evaluated as follows.

### <Evaluation criteria for relative permittivity>

Excellent: 2.3 or less
Good: more than 2.3 and 2.6 or less
Acceptable: more than 2.6 and 3.0 or less
Unsatisfactory: more than 3.0

### <Evaluation criteria for dielectric dissipation factor>

Excellent: 0.006 or less
Good: more than 0.006 and 0.009 or less
Acceptable: more than 0.009 and 0.015 or less
Unsatisfactory: more than 0.015

### (4) Insulation reliability

An adhesive composition, which will be described later, was applied to a 12.5 µm thick polyimide film (Apical (registered trademark), manufactured by Kaneka) so that the adhesive composition would have a thickness of 25 µm when dried. The adhesive composition on the polyimide film was dried at 130°C for 3 minutes. Subsequently, the resulting adhesive film (B stage product) was heat-pressed by a vacuum press laminating machine to form a comb pattern with a line-to-space ratio (L/S) of 50/50 µm at 160°C and 3 MPa for 30 seconds under reduced pressure. The adhesive composition was then cured by heating at 140°C for 4 hours. The insulation reliability was evaluated by applying a voltage of 200 V for 250 hours in an environment of 85°C and a humidity of 85%.

### <Evaluation criteria>

Unsatisfactory: short-circuit occurred within 250 hours.

Acceptable: No short-circuit occurred after 250 hours, and the resistance value was less than 1 × 10⁸ Ω. It was judged that no dendrite was generated.

Good: No short-circuit occurred after 250 hours, and the resistance value was 1 × 10⁸ Ω or more. It was judged that no dendrite was generated.

### (5) Flame retardance

An adhesive composition, which will be described later, was applied to a 25 µm thick polyimide film (Apical (registered trademark), manufactured by Kaneka) so that the adhesive composition would have a thickness of 25 µm when dried. The adhesive composition on the polyimide film was dried at 130°C for 3 minutes. Subsequently, the polyimide film coated with the adhesive composition was adhered with another polyimide film by a roll laminator at a roll temperature of 100°C, a lamination speed of 30 m/min, and a lamination pressure of 23.6 N/cm. The adhesive composition was then cured through a heat treatment at 140°C for 4 hours and a laminate was obtained. A test piece was prepared from the laminate, and burning test was conducted with the test piece to determine VTM rate according to UL 94 standards.

### <Evaluation criteria>

Good: equivalent to VTM-0
Acceptable: equivalent to VTM-1
Unsatisfactory: equivalent to or below VTM-2

### Example 1

First, 100 parts by mass of acid-modified polyolefin a-1, 10 parts by mass of epoxy resin HP-7200H, 20 parts by mass of phosphorus flame retardant SR-3000, and an organic solvent (methylcyclohexane/toluene=80/20, v/v: volume ratio) were blended to obtain a mixed solution. In Table 1, components percentages, adhesive strength, solder heat resistance, electrical properties, insulation reliability, and flame retardance are shown. The organic solvent (methylcyclohexane/toluene=80/20, v/v: volume ratio) was prepared to have a solids concentration of 20% by mass.

### Examples 2 to 20

Examples 2 to 20 were conducted in the same manner as Example 1 except that the types and the amounts of components were changed as shown in Table 1. In Table 1, adhesive strength, solder heat resistance, electrical properties, insulation reliability, and flame retardance are shown. The organic solvent (methylcyclohexane/toluene=80/20, v/v: volume ratio) was prepared to have a solids concentration of 20% by mass.

### Comparative Examples 1 to 5

Comparative Examples 1 to 5 were conducted in the same manner as Example 1 except that the types and the amounts of components were changed as shown in Table 1. In Table 1, adhesive strength, solder heat resistance, electrical properties, insulation reliability, and flame retardance are shown. The organic solvent (methylcyclohexane/toluene=80/20, v/v: volume ratio) was prepared to have a solids concentration of 20% by mass.

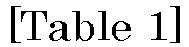

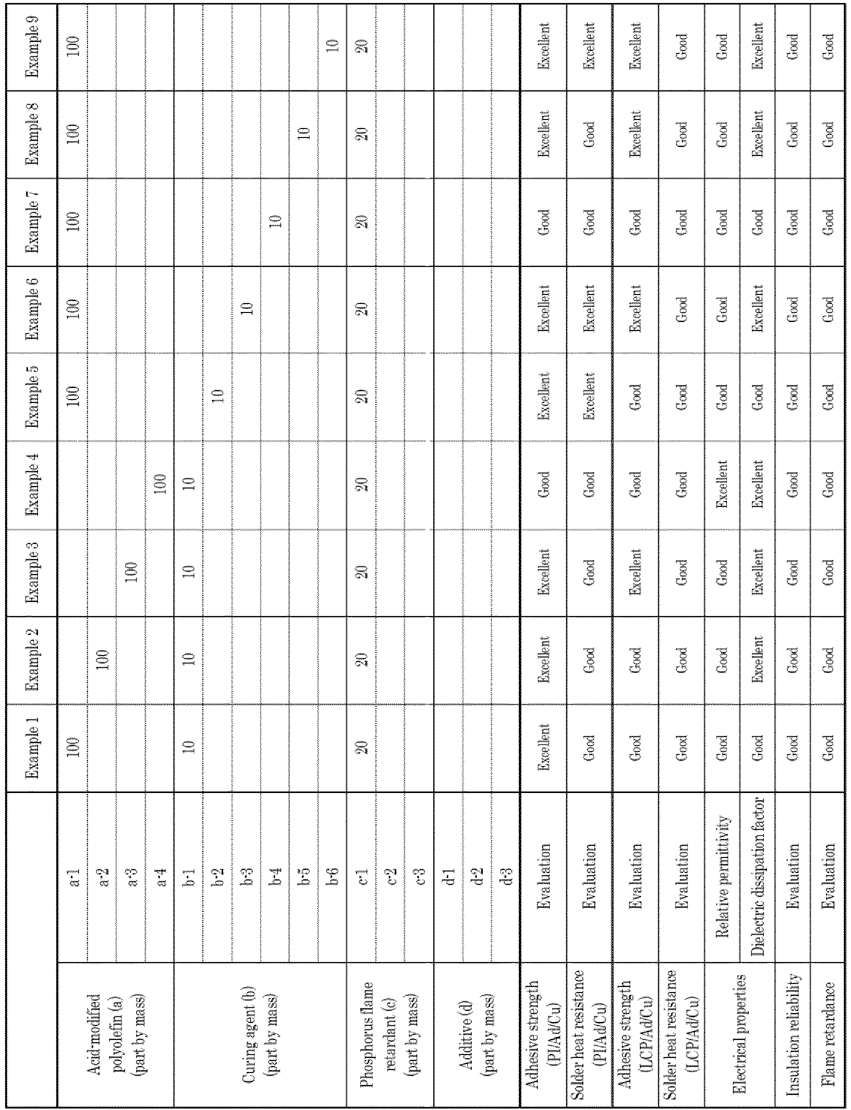

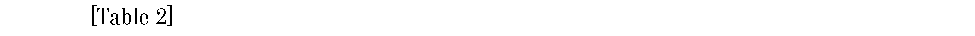

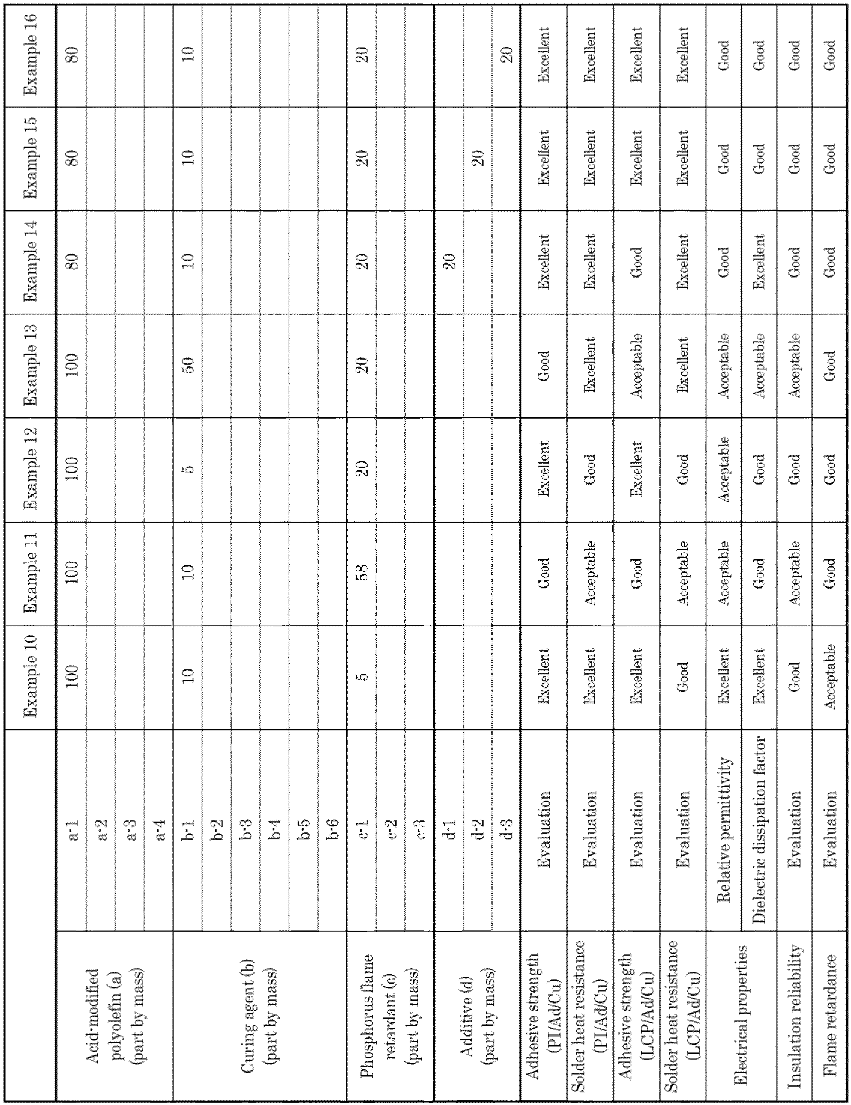

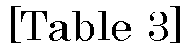

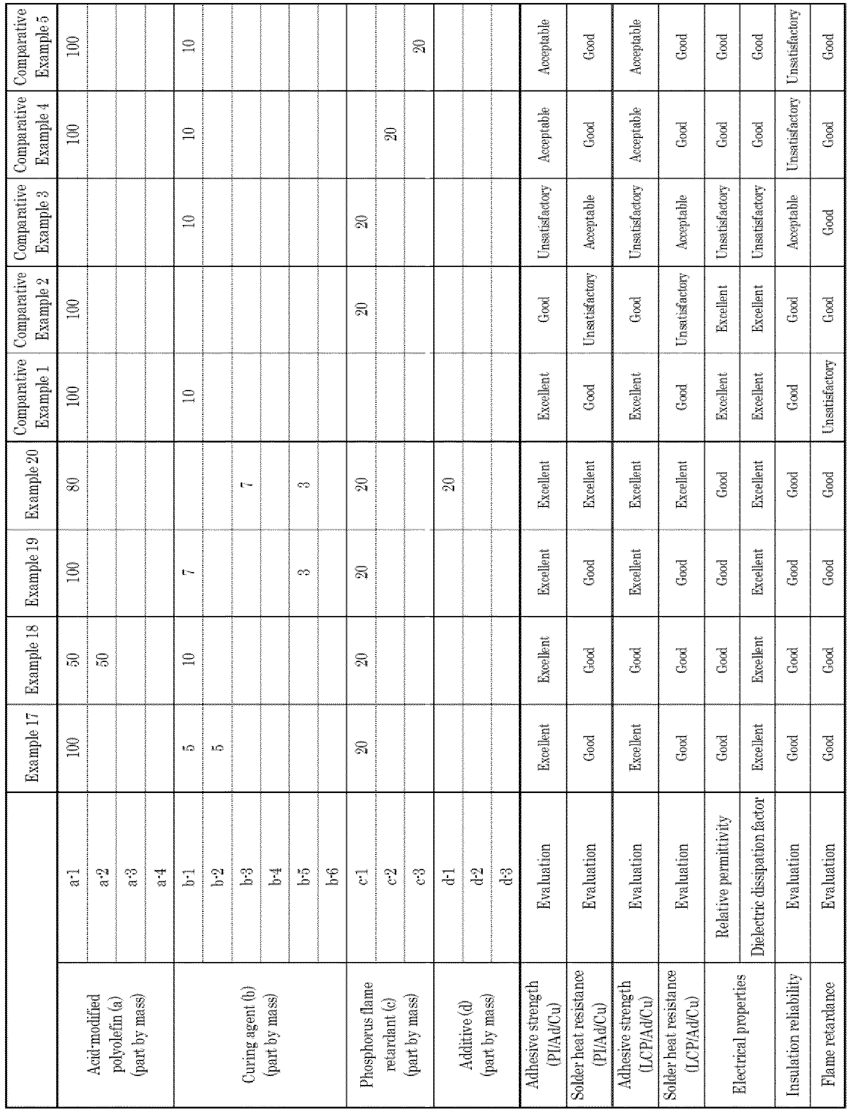

In Tables 1 to 3, "PI/Ad/Cu" represents a sample for evaluation prepared by adhering a polyimide film and a rolled copper foil with an adhesive composition, and "LCP/Ad/C" represents a sample for evaluation prepared by adhering an LCP film and a rolled copper foil with an adhesive composition.

The curing agents (b), the phosphorus flame retardants (c), and the additives (d) shown in Tables 1 to 3 are as follows.

### (Curing agent (b))

### (Epoxy resin)

b-1: Dicyclopentadiene-type epoxy resin: HP-7200H (manufactured by DIC, epoxy equivalent: 278 g/eq)
b-2: Cresol novolac type epoxy resin: jER-152 (manufactured by Mitsubishi Chemical Corporation, epoxy equivalent 177 g/eq)
b-3: Glycidylamine type epoxy resin: jER-630 (manufactured by Mitsubishi Chemical Corporation, epoxy equivalent 98 g/eq)

### (Polyisocyanate )

b-4: Isocyanurate of hexamethylene diisocyanate: SUMIDUR (Registered trademark) N-3300 (manufactured by Sumika Bayer Urethane Co., Ltd.)

### (Polycarbodiimide)

b-5: Carbodiimide resin: V-09GB (manufactured by Nisshinbo Chemical Inc., carbodiimide equivalent: 216 g/eq)
b-6: Carbodiimide resin: V-03 (manufactured by Nisshinbo Chemical Inc., carbodiimide equivalent: 209 g/eq)

### (Phosphorus flame retardant (c))

c-1: SR-3000 (manufactured by DAIHACHI CHEMICAL INDUSTRY CO., LTD.): a flame retardant containing a compound represented by Formula (2); an amorphous phosphate ester flame retardant containing an alicyclic structure and an aromatic ring.
c-2: PX-200 (manufactured by DAIHACHI CHEMICAL INDUSTRY CO., LTD.): a flame retardant containing 1,3-phenylene-tetrakis(2,6-dimethylphenyl) phosphate; a crystalline phosphate ester flame retardant containing an aromatic ring but not an alicyclic structure.
c-3: PX-202 (manufactured by DAIHACHI CHEMICAL INDUSTRY CO., LTD.): a flame retardant containing 4,4' -biphenylene-tetrakis(2,6-dimethylphenyl) phosphate; a crystalline phosphate ester flame retardant containing an aromatic ring but not an alicyclic structure.

### (Additive (d))

d-1: OPE-2St 2200; a styrene-modified oligo-phenylene ether having a structure represented by Formula (9), Mn: 2000, manufactured by Mitsubishi Gas Chemical.
d-2: SA90; an oligo-phenylene ether having a structure represented by Formula (8), Mn: 1800, manufactured by SABIC.
d-3: SA9000; a methacrylic-modified oligo-phenylene ether having a structure represented by Formula (10), Mn: 1700, manufactured by SABIC.

The acid-modified polyolefins (a) shown in Table 1 were produced as follows.

### Preparation Example 1

In a 1L autoclave, 100 parts by mass of propylene-butene copolymer (Tafmer (registered trademark) XM7080, manufactured by Mitsui Chemicals, Inc.), 150 parts by mass of toluene, 19 parts by mass of maleic anhydride, and 6 parts by mass of di-tert-butyl peroxide were introduced, and heated to 140°C. Following 3 hours of stirring, the resulting reaction solution was cooled and poured into a container containing a large amount of methyl ethyl ketone to precipitate a resin. The resulting liquid containing the resin was then subjected to centrifugation to separate acid-modified propylene-butene copolymer in which maleic anhydride was grafted from (poly)maleic anhydride and low-molecular substances. Then, by drying at 70°C for 5 hours under reduced pressure, the propylene-butene copolymer modified with maleic anhydride was obtained (a-1, acid value: 19 mgKOH/g, Mn: 25,000, Tm: 80°C, ΔH: 35 J/g).

### Preparation Example 2

A propylene-butene copolymer modified with maleic anhydride (a-2, acid value: 14 mgKOH/g, Mn: 30,000, Tm: 78°C, ΔH: 25 J/g) was produced in the same manner as Preparation Example 1 except that the amount of maleic anhydride was changed to 14 parts by mass.

### Preparation Example 3

A propylene-butene copolymer modified with maleic anhydride (a-3, acid value: 11 mgKOH/g, Mn: 33,000, Tm: 80°C, ΔH: 25 J/g) was produced in the same manner as Preparation Example 1 except that the amount of maleic anhydride was changed to 11 parts by mass.

### Preparation Example 4

A propylene-butene copolymer modified with maleic anhydride (a-4, acid value: 7 mgKOH/g, Mn: 35,000, Tm: 82°C, ΔH: 25 J/g) was produced in the same manner as Preparation Example 1 except that the amount of maleic anhydride was changed to 6 parts by mass.

As shown in Table 1, the adhesive compositions in Examples 1 to 20 exhibited high adhesiveness as adhesives to polyimide (PI), LCP, and a metal foil, as well as excellent solder heat resistance, insulation reliability, and flame retardance. In contrast, in Comparative Example 1, the adhesive composition did not comprise a phosphorus flame retardant (c), leading to inferior flame retardance. In Comparative Example 2, the adhesive composition did not comprise a curing agent (b), leading to a decrease in solder heat resistance. In Comparative Example 3, the adhesive composition did not comprise a polyolefin resin (a), leading to inferior adhesiveness. In Comparative Examples 4 and 5, the adhesive composition comprised a phosphorus flame retardant (c) not containing an alicyclic structure, resulting in a decrease in insulation reliability and adhesive strength.

### INDUSTRIAL APPLICABILITY

The adhesive composition of the present invention has high adhesiveness to conventionally used polyimide or liquid crystal polymer substrates as well as metal substrates such as copper foil. Further, the adhesive composition has excellent solder heat resistance, excellent low dielectric properties, high flame retardance, and high insulation reliability. The adhesive composition of the present invention enables the production of an adhesive sheet and a laminate that is bonded by the adhesive sheet. Due to the characteristics mentioned above, the adhesive composition of the present invention is useful in applications for flexible printed circuit boards (FPCs), specifically in cases where low dielectric properties (low dielectric constant and low dielectric dissipation factor) in a high-frequency range are required, as well as for electromagnetic wave shield materials.

## Claims

1. An adhesive composition comprising an acid-modified polyolefin (a), a curing agent (b), and a phosphorus flame retardant (c), wherein the phosphorus flame retardant (c) contains an alicyclic structure in a molecule.

2. The adhesive composition according to claim 1, wherein the adhesive composition comprises the phosphorus flame retardant (c) in an amount of from 1 to 60 parts by mass with respect to 100 parts by mass of the total amount of the acid-modified polyolefin (a) and the curing agent (b).

3. The adhesive composition according to claim 1 or 2, wherein the acid-modified polyolefin (a) has an acid value of from 5 to 40 mgKOH/g.

4. The adhesive composition according to any one of claims 1 to 3, wherein the curing agent (b) comprises at least one selected from the group consisting of epoxy resins, polyisocyanates, and polycarbodiimides.

5. The adhesive composition according to any one of claims 1 to 4, wherein the phosphorus flame retardant (c) further contains an aromatic ring in a molecule.

6. The adhesive composition according to any one of claims 1 to 5, wherein the phosphorus flame retardant (c) is amorphous.

7. The adhesive composition according to any one of claims 1 to 6, wherein the adhesive composition comprises the curing agent (b) in an amount of from 0.5 to 60 parts by mass with respect to 100 parts by mass of the acid-modified polyolefin (a).

8. The adhesive composition according to any one of claims 1 to 7, wherein the adhesive composition has a relative permittivity at 10 GHz of 3.0 or less and a dielectric dissipation factor at 10 GHz of 0.02 or less.

9. An adhesive sheet comprising a layer including the adhesive composition according to any one of claims 1 to 8.

10. An electromagnetic wave shield film comprising a layer including the adhesive composition according to any one of claims 1 to 8.

11. A laminate comprising a layer including the adhesive composition according to any one of claims 1 to 8.

12. A printed circuit board comprising the laminate according to claim 11.

## Patentansprüche

1. Haftmittelzusammensetzung, umfassend ein säuremodifiziertes Polyolefin (a), ein Härtungsmittel (b) und ein Phosphorflammschutzmittel (c), wobei das Phosphorflammschutzmittel (c) eine alicyclische Struktur in einem Molekül enthält.

2. Haftmittelzusammensetzung nach Anspruch 1, wobei die Haftmittelzusammensetzung das Phosphorflammschutzmittel (c) in einer Menge von 1 bis 60 Masseteilen, bezogen auf 100 Masseteile der Gesamtmenge des säuremodifizierten Polyolefins (a) und des Härtungsmittels (b), umfasst.

3. Haftmittelzusammensetzung nach Anspruch 1 oder 2, wobei das säuremodifizierte Polyolefin (a) eine Säurezahl von 5 bis 40 mg KOH/g aufweist.

4. Haftmittelzusammensetzung nach einem der Ansprüche 1 bis 3, wobei das Härtungsmittel (b) mindestens eines, ausgewählt aus der Gruppe, bestehend aus Epoxidharzen, Polyisocyanaten und Polycarbodiimiden, umfasst.

5. Haftmittelzusammensetzung nach einem der Ansprüche 1 bis 4, wobei das Phosphorflammschutzmittel (c) weiter einen aromatischen Ring in einem Molekül enthält.

6. Haftmittelzusammensetzung nach einem der Ansprüche 1 bis 5, wobei das Phosphorflammschutzmittel (c) amorph ist.

7. Haftmittelzusammensetzung nach einem der Ansprüche 1 bis 6, wobei die Haftmittelzusammensetzung das Härtungsmittel (b) in einer Menge von 0,5 bis 60 Masseteilen, bezogen auf 100 Masseteile des säuremodifizierten Polyolefins (a), umfasst.

8. Haftmittelzusammensetzung nach einem der Ansprüche 1 bis 7, wobei die Haftmittelzusammensetzung eine relative Dielektrizitätskonstante bei 10 GHz von 3,0 oder weniger und einen dielektrischen Verlustfaktor bei 10 GHz von 0,02 oder weniger aufweist.

9. Haftfolie, umfassend eine Schicht, die die Haftmittelzusammensetzung nach einem der Ansprüche 1 bis 8 beinhaltet.

10. Elektromagnetischer Wellenabschirmfilm, umfassend eine Schicht, die die Haftmittelzusammensetzung nach einem der Ansprüche 1 bis 8 beinhaltet.

11. Laminat, umfassend eine Schicht, die die Haftmittelzusammensetzung nach einem der Ansprüche 1 bis 8 beinhaltet.

12. Leiterplatte, umfassend das Laminat nach Anspruch 11.

## Revendications

1. Composition adhésive comprenant une polyoléfine modifiée par un acide (a), un agent durcissant (b) et un ignifuge de phosphore (c), dans laquelle l'ignifuge de phosphore (c) contient une structure alicyclique dans une molécule.

2. Composition adhésive selon la revendication 1, dans laquelle la composition adhésive comprend l'ignifuge de phosphore (c) en une quantité allant de 1 à 60 parties en masse par rapport à 100 parties en masse de la quantité totale de la polyoléfine modifiée par un acide (a) et l'agent durcissant (b).

3. Composition adhésive selon la revendication 1 ou 2, dans laquelle la polyoléfine modifiée par un acide (a) a une valeur acide allant de 5 à 40 mgKOH/g.

4. Composition adhésive selon l'une quelconque des revendications 1 à 3, dans laquelle l'agent durcissant (b) comprend au moins un composé sélectionné parmi le groupe constitué de résines époxy, polyisocyanates et polycarbodiimides.

5. Composition adhésive selon l'une quelconque des revendications 1 à 4, dans laquelle l'ignifuge de phosphore (c) contient en outre un cycle aromatique dans une molécule.

6. Composition adhésive selon l'une quelconque des revendications 1 à 5, dans laquelle l'ignifuge de phosphore (c) est amorphe.

7. Composition adhésive selon l'une quelconque des revendications 1 à 6, dans laquelle la composition adhésive comprend l'agent durcissant (b) en une quantité allant de 0,5 à 60 parties en masse par rapport à 100 parties en masse de la polyoléfine modifiée par un acide (a).

8. Composition adhésive selon l'une quelconque des revendications 1 à 7, dans laquelle la composition adhésive a une permittivité relative à 10 GHz de 3,0 ou moins et un facteur de dissipation diélectrique à 10 GHz de 0,02 ou moins.

9. Feuille adhésive comprenant une couche incluant la composition adhésive selon l'une quelconque des revendications 1 à 8.

10. Film protecteur d'onde électromagnétique comprenant une couche incluant la composition adhésive selon l'une quelconque des revendications 1 à 8.

11. Stratifié comprenant une couche incluant la composition adhésive selon l'une quelconque des revendications 1 à 8.

12. Carte de circuit imprimé comprenant le stratifié selon la revendication 11.
